# EUROPEAN PATENT APPLICATION

(11) **EP 4 852 322 A1**
(43) Date of publication of application: **09.12.2026**
(21) Application number: 26182934.5
(22) Date of filing: 03.06.2026
(51) Int. Cl.: H03K 17/0412

(54) **TURN-OFF CONTROL METHOD AND APPARATUS, ELECTRONIC DEVICE, STORAGE MEDIUM, PROGRAM PRODUCT, AND HYBRID SWITCHING APPARATUS**

(30) Priority: 04.06.2025 CN 202510744145
(71) Applicant: Siemens Aktiengesellschaft, 80333 München (DE)
(72) Inventor: LU, Hai Ping, Suzhou, JS, 215129 (CN); WANG, Mou, Suzhou, JS, 215129 (CN); YUAN, Tao, Suzhou, JS, 215129 (CN)
(74) Representative: HKW Intellectual Property PartG mbB

(57) **Abstract**

The present invention provides a turn-off control method and apparatus, an electronic device, a storage medium, a program product, and a hybrid switching apparatus. The method includes: sending turn-off control data to a hybrid switching apparatus when the hybrid switching apparatus is in an on state, to turn on a first solid-state switch and a second solid-state switch that are included in the hybrid switching apparatus, and turn off a first mechanical switch and a second mechanical switch that are included in the hybrid switching apparatus, where the first mechanical switch is connected in parallel with the first solid-state switch, and the second mechanical switch is connected in parallel with the second solid-state switch; and controlling the first solid-state switch and the second solid-state switch to be turned off after current flows normally through the first solid-state switch and current flows normally through the second solid-state switch, to switch the hybrid switching apparatus to an off state. The present invention improves the operating performance of the hybrid switching apparatus.

## Description

### TECHNICAL FIELD

This application relates to the field of switch control technologies, and in particular, to a turn-off control method and apparatus, an electronic device, a storage medium, a program product, and a hybrid switching apparatus.

### BACKGROUND

A hybrid switch is a switch that combines a mechanical switch and an electronic switch, offering advantages such as high precision and high reliability. Compared with single-pole hybrid switches, double-pole hybrid switches can be used in direct-current circuits with higher current.

A current double-pole hybrid switch consists of two independent single-pole hybrid switches. When a double-pole hybrid switch in a circuit is to be turned off, the two single-pole hybrid switches are controlled independently to interrupt the circuit in which the double-pole hybrid switch is located.

However, the two single-pole hybrid switches in the double-pole hybrid switch are controlled independently. Therefore, when the double-pole hybrid switch is being turned off, the turn-off sequence and turn-off time interval of the electronic switches inside the two single-pole hybrid switches exhibit considerable randomness. As a result, the coordination between the two single-pole hybrid switches is poor during turn-off of the double-pole hybrid switch, making arcing more likely to occur. This issue is particularly pronounced when the double-pole hybrid switch is used in direct-current circuits with high current, where arcing is even more likely to occur, leading to poor operating performance of the double-pole hybrid switch.

### SUMMARY

In view of this, this application provides a turn-off control method and apparatus, an electronic device, a storage medium, a program product, and a hybrid switching apparatus, to improve the operating performance of the hybrid switching apparatus.

According to a first aspect of embodiments of this application, a turn-off control method is provided, including: sending turn-off control data to a hybrid switching apparatus when the hybrid switching apparatus is in an on state, to turn on a first solid-state switch and a second solid-state switch that are included in the hybrid switching apparatus, and turn off a first mechanical switch and a second mechanical switch that are included in the hybrid switching apparatus, where the on state is a state in which the first mechanical switch and the second mechanical switch that are included in the hybrid switching apparatus are turned on and the first solid-state switch and the second solid-state switch are turned off, the first mechanical switch is connected in parallel with the first solid-state switch, and the second mechanical switch is connected in parallel with the second solid-state switch; and controlling the first solid-state switch and the second solid-state switch to be turned off after current flows normally through the first solid-state switch and current flows normally through the second solid-state switch, to switch the hybrid switching apparatus to an off state.

According to a second aspect of the embodiments of this application, a turn-off control apparatus is provided, including: a sending unit, configured to send turn-off control data to a hybrid switching apparatus when the hybrid switching apparatus is in an on state, to turn on a first solid-state switch and a second solid-state switch that are included in the hybrid switching apparatus, and turn off a first mechanical switch and a second mechanical switch that are included in the hybrid switching apparatus, where the on state is a state in which the first mechanical switch and the second mechanical switch that are included in the hybrid switching apparatus are turned on and the first solid-state switch and the second solid-state switch are turned off, the first mechanical switch is connected in parallel with the first solid-state switch, and the second mechanical switch is connected in parallel with the second solid-state switch; and a turn-off unit, configured to control the first solid-state switch and the second solid-state switch to be turned off after current flows normally through the first solid-state switch and current flows normally through the second solid-state switch, to switch the hybrid switching apparatus to an off state.

According to a third aspect of the embodiments of this application, an electronic device is provided, including: a processor, a communication interface, a memory, and a bus, where the processor, the communication interface, and the memory communicate with each other through the bus; and the memory is configured to store at least one executable instruction, and the executable instruction causes the processor to perform operations corresponding to the method in the foregoing first aspect.

According to a fourth aspect of the embodiments of this application, a computer-readable storage medium is provided, having computer instructions stored therein, where the computer instructions, when executed by a processor, cause the processor to perform the method in the foregoing first aspect.

According to a fifth aspect of the embodiments of this application, a computer program product is provided, tangibly stored in a computer-readable medium and including computer-executable instructions, where the computer-executable instructions, when executed, cause at least one processor to perform the method in the foregoing first aspect.

According to a sixth aspect of the embodiments of this application, a hybrid switching apparatus is provided, including: a first mechanical switch, a first solid-state switch, a second mechanical switch, and a second solid-state switch, where the first mechanical switch is connected in parallel with the first solid-state switch, and the second mechanical switch is connected in parallel with the second solid-state switch; the first mechanical switch and the second mechanical switch are both configured to be turned off after a turn-off control apparatus connected to the hybrid switching apparatus sends at least some turn-off control data to the hybrid switching apparatus when the hybrid switching apparatus is in an on state, where the on state is a state in which the first mechanical switch and the second mechanical switch that are included in the hybrid switching apparatus are turned on and the first solid-state switch and the second solid-state switch are turned off; and the first solid-state switch and the second solid-state switch are both configured to be turn on after the turn-off control apparatus sends at least some turn-off control data to the hybrid switching apparatus and turned off after current flows normally through the first solid-state switch and current flows normally through the second solid-state switch when the hybrid switching apparatus is in the on state, to switch the hybrid switching apparatus to an off state.

According to the foregoing technical solution, the turn-off control data may be sent to the hybrid switching apparatus when the hybrid switching apparatus is in the on state, to turn on the first solid-state switch and the second solid-state switch that are included in the hybrid switching apparatus, and turn off the first mechanical switch and the second mechanical switch that are included in the hybrid switching apparatus. Then, the first solid-state switch and the second solid-state switch are controlled to be turned off after current flows normally through the first solid-state switch and current flows normally through the second solid-state switch, to switch the hybrid switching apparatus to the off state. Therefore, in a process of turning off the hybrid switching apparatus, the first solid-state switch and the second solid-state switch are turned off after current flows normally through both the first solid-state switch and the second solid-state switch, so that randomness of a turn-off sequence and a turn-off time interval of the first solid-state switch and the second solid-state switch is low, the coordination between the switches inside the hybrid switching apparatus is improved, a possibility of generating an arc in the process of turning off the hybrid switching apparatus is reduced, and the operating performance of the hybrid switching apparatus is improved.

### BRIEF DESCRIPTION OF THE DRAWINGS

FIG. 1 is a circuit diagram of a hybrid switching apparatus according to an embodiment of this application;
FIG. 2 is a schematic diagram of a first main circuit according to an embodiment of this application;
FIG. 3 is a schematic diagram of a second main circuit according to an embodiment of this application;
FIG. 4 is a schematic diagram of a third main circuit according to an embodiment of this application;
FIG. 5 is a schematic diagram of a fourth main circuit according to an embodiment of this application;
FIG. 6 is a schematic diagram of a fifth main circuit according to an embodiment of this application;
FIG. 7 is a flowchart of a turn-off control method according to an embodiment of this application;
FIG. 8 is a schematic diagram for presenting a time sequence relationship according to an embodiment of this application;
FIG. 9 is a schematic diagram of a turn-off control apparatus according to an embodiment of this application; and
FIG. 10 is a schematic diagram of an electronic device according to an embodiment of this application.

### List of Reference Numerals:

701: Send turn-off control data to a hybrid switching apparatus when the hybrid switching apparatus is in an on state, to turn on a first solid-state switch and a second solid-state switch that are included in the hybrid switching apparatus, and turn off a first mechanical switch and a second mechanical switch that are included in the hybrid switching apparatus
702: Control the first solid-state switch and the second solid-state switch to be turned off after current flows normally through the first solid-state switch and current flows normally through the second solid-state switch, to switch the hybrid switching apparatus to an off state

| | | | | | |
|---|---|---|---|---|---|
| 100: | Hybrid switching apparatus | 101: | Driving unit | 102: | First mechanical switch |
| 103: | First solid-state switch | 104: | Second mechanical switch | 105: | Second solid-state switch |
| 106: | First disconnector | 107: | Second disconnector | 700: | Turn-off control method |
| 900: | Turn-off control apparatus | 901: | Sending unit | 902: | Turn-off unit |
| 1000: | Electronic device | 1002: | Processor | 1104: | Communication |
| | | | | interface | |
| 1006: | Memory | 1008: | Memory | 1010: | Program |
| D1: | First amplification module | R1: | First resistor | C1: | First capacitor |
| D2: | Second amplification module | R2: | Second resistor | C2: | Second capacitor |
| T1: | First transistor | T2: | Second transistor | L1: | First diode |
| L2: | Second diode | T3: | Third transistor | T4: | Fourth transistor |
| L3: | Third diode | L4: | Fourth diode | a1: | First connection terminal |
| a2: | Second connection terminal | a3: | Third connection terminal | | |

### DETAILED DESCRIPTION

As described above, a current double-pole hybrid switch consists of two independent single-pole hybrid switches. When a double-pole hybrid switch in a circuit is to be turned off, the two single-pole hybrid switches are controlled independently to interrupt the circuit in which the double-pole hybrid switch is located. However, the two single-pole hybrid switches in the double-pole hybrid switch are controlled independently. Therefore, when the double-pole hybrid switch is being turned off, the turn-off sequence of the mechanical switches and the turn-off sequence of the electronic switches inside the two single-pole hybrid switches exhibit considerable randomness. As a result, the coordination between the two single-pole hybrid switches is poor during turn-off of the double-pole hybrid switch, making arcing more likely to occur. This issue is particularly pronounced when the double-pole hybrid switch is used in direct-current circuits with high current, where arcing is even more likely to occur, leading to poor operating performance of the double-pole hybrid switch.

In the embodiments of this application, the turn-off control data may be sent to the hybrid switching apparatus when the hybrid switching apparatus is in the on state, to turn on the first solid-state switch and the second solid-state switch that are included in the hybrid switching apparatus, and turn off the first mechanical switch and the second mechanical switch that are included in the hybrid switching apparatus. Then, the first solid-state switch and the second solid-state switch are controlled to be turned off after current flows normally through the first solid-state switch and current flows normally through the second solid-state switch, to switch the hybrid switching apparatus to the off state. Therefore, in a process of turning off the hybrid switching apparatus, the first solid-state switch and the second solid-state switch are turned off after current flows normally through both the first solid-state switch and the second solid-state switch, so that randomness of a turn-off sequence and a turn-off time interval of the first solid-state switch and the second solid-state switch is low, the coordination between the switches inside the hybrid switching apparatus is improved, a possibility of generating an arc in the process of turning off the hybrid switching apparatus is reduced, and the operating performance of the hybrid switching apparatus is improved.

The following describes a turn-off control method and apparatus, an electronic device, a storage medium, a program product, and a hybrid switching apparatus that are provided in embodiments of this application in detail with reference to the accompanying drawings.

### Turn-off control method

The turn-off control method provided in this embodiment of this application may be applied to a turn-off control apparatus connected to a hybrid switching apparatus. The turn-off control apparatus is, for example, a microcontroller unit (MCU), which is not limited in this embodiment of this application. The turn-off control method is used for controlling the hybrid switching apparatus to switch from an on state to an off state after the turn-off control apparatus sends turn-off control data to the hybrid switching apparatus, to interrupt a main circuit in which the hybrid switching apparatus is used. The turn-off control data may include a turn-on control signal and a turn-off control signal.

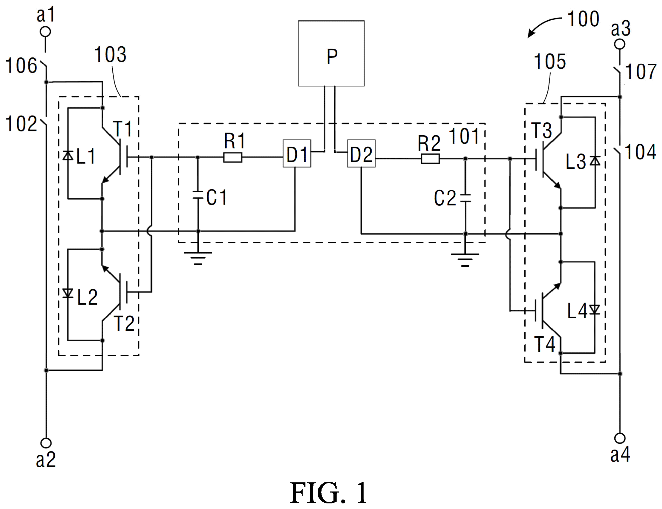

FIG. 1 is a circuit diagram of a hybrid switching apparatus according to an embodiment of this application. As shown in FIG. 1, the hybrid switching apparatus 100 includes a driving unit 101, a first mechanical switch 102, a first solid-state switch 103, a second mechanical switch 104, a second solid-state switch 105, a first disconnector 106, and a second disconnector 107. The driving unit 101 is connected to the first solid-state switch 103, and the driving unit 101 is connected to the second solid-state switch 105. The first mechanical switch 102 is connected in parallel with the first solid-state switch 103, and the second mechanical switch 104 is connected in parallel with the second solid-state switch 105. Based on this, when the hybrid switching apparatus 100 is in an on state, the first mechanical switch 102 and the second mechanical switch 104 are turned on, and the first solid-state switch 103 and the second solid-state switch 105 are turned off. When the hybrid switching apparatus 100 is in an off state, the first mechanical switch 102 and the second mechanical switch 104 are turned off, and the first solid-state switch 103 and second solid-state switch 105 are turned off. It needs to be noted that P in FIG. 1 may be an output module that is included in the turn-off control apparatus 900 and that is configured to output a turn-on control signal. The output module is, for example, a module in the following sending unit 901. A specific circuit structure of the output module is not limited in this embodiment of this application.

As shown in FIG. 1, the driving unit 101 includes a first amplification module D1, a first resistor R1, a first capacitor C1, a second amplification module D2, a second resistor R2, and a second capacitor C2. An input terminal of the first amplification module D1 is connected to the turn-off control apparatus 900. An output terminal of the first amplification module D1 is connected to a first terminal of the first resistor R1. A ground terminal of the first amplification module D1 is connected to ground. A second terminal of the first resistor R1 is a first output terminal of the driving unit 101. A first terminal of the first capacitor C1 is connected to the second terminal of the first resistor R1. A second terminal of the first capacitor C1 is connected to ground. An input terminal of the second amplification module D2 is connected to the turn-off control apparatus 900. An output terminal of the second amplification module D2 is connected to a first terminal of the second resistor R2. A ground terminal of the second amplification module D2 is connected to ground. A second terminal of the second resistor R2 is a second output terminal of the driving unit 101. A first terminal of the second capacitor C2 is connected to the second terminal of the second resistor R2. A second terminal of the second capacitor C2 is connected to ground.

The first amplification module D1 and the second amplification module D2 may both use a signal amplification circuit and the like. This is not limited in this embodiment of this application. The ground terminal of the first amplification module D1 being connected to ground may enable the first amplification module D1 to be in a normal operating state, and the ground terminal of the second amplification module D2 being connected to ground may enable the second amplification module D2 to be in a normal operating state.

As shown in FIG. 1, a first terminal of the first mechanical switch 102 is connected to a first terminal of the first disconnector 106. A first connection terminal a1 of the hybrid switching apparatus 100 is connected to a second terminal of the first disconnector 106. A second connection terminal a2 of the hybrid switching apparatus 100 is connected to a second terminal of the first mechanical switch 102. A first terminal of the second mechanical switch 104 is connected to a first terminal of the second disconnector 107. A third connection terminal a3 of the hybrid switching apparatus 100 is connected to a second terminal of the second disconnector 107. A fourth connection terminal a4 of the hybrid switching apparatus 100 is connected to a second terminal of the second mechanical switch 104. The first connection terminal a1, the second connection terminal a2, the third connection terminal a3, and the fourth connection terminal a4 of the hybrid switching apparatus 100 are all terminals configured to be connected to elements in a main circuit, to enable the hybrid switching apparatus 100 to be connected in the main circuit.

As shown in FIG. 1, the first solid-state switch 103 includes a first transistor T1, a second transistor T2, a first diode L1, and a second diode L2. The second solid-state switch 105 includes a third transistor T3, a fourth transistor T4, a third diode L3, and a fourth diode L4. The first transistor T1, the second transistor T2, the third transistor T3, and the fourth transistor T4 are all N-channel insulated gate bipolar transistors.

As shown in FIG. 1, a gate of the first transistor T1 is connected to the first output terminal of the driving unit 101. A collector of the first transistor T1 is connected to the first terminal of the first mechanical switch 102. An emitter of the first transistor T1 is connected to an emitter of the second transistor T2. A gate of the second transistor T2 is connected to the first output terminal of the driving unit 101. A collector of the second transistor T2 is connected to the second terminal of the first mechanical switch 102. The emitter of the first transistor T1 and the emitter of the second transistor T2 are connected to ground. An anode of the first diode L1 is connected to the emitter of the first transistor T1. A cathode of the first diode L1 is connected to the collector of the first transistor T1. An anode of the second diode L2 is connected to the emitter of the second transistor T2. A cathode of the second diode L2 is connected to the collector of the second transistor T2.

As shown in FIG. 1, a gate of the third transistor T3 is connected to the second output terminal of the driving unit 101. A collector of the third transistor T3 is connected to the first terminal of the second mechanical switch 104. An emitter of the third transistor T3 is connected to an emitter of the fourth transistor T4. A gate of the fourth transistor T4 is connected to the second output terminal of the driving unit 101. A collector of the fourth transistor T4 is connected to the second terminal of the second mechanical switch 104. The emitter of the third transistor T3 and the emitter of the fourth transistor T4 are connected to ground. An anode of the third diode L3 is connected to the emitter of the third transistor T3. A cathode of the third diode L3 is connected to the collector of the third transistor T3. An anode of the fourth diode L4 is connected to the emitter of the fourth transistor T4. A cathode of the fourth diode L4 is connected to the collector of the fourth transistor T4.

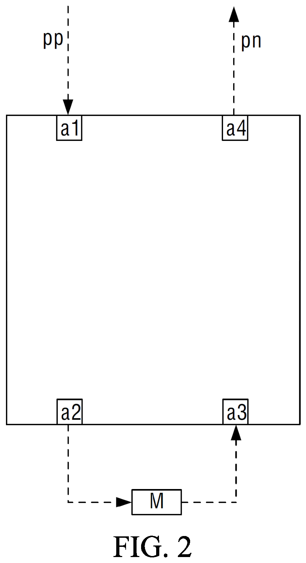

Based on the foregoing hybrid switching apparatus 100, the main circuit may have at least the following several implementations:
In a first possible implementation, as shown in FIG. 2, the main circuit further includes a power supply and a load. The first connection terminal a1 of the hybrid switching apparatus 100 is connected to a positive electrode of the power supply. The load is connected between the second connection terminal a2 of the hybrid switching apparatus 100 and the third connection terminal a3 of the hybrid switching apparatus 100. The fourth connection terminal a4 of the hybrid switching apparatus 100 is connected to a negative electrode of the power supply.

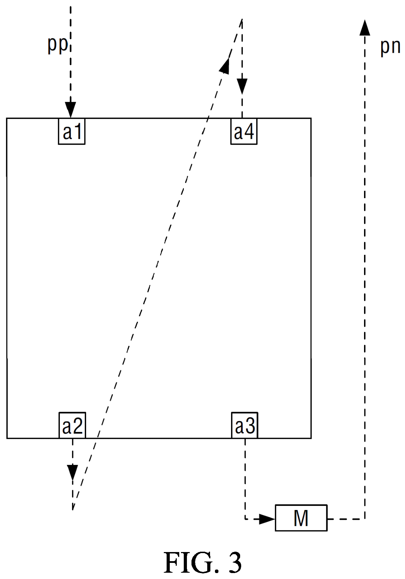

It needs to be noted that in FIG. 2 and the following FIG. 3, FIG. 4, and FIG. 5, pp is the positive electrode of the power supply, pn is the negative electrode of the power supply, and M is the load.

In a second possible implementation, as shown in FIG. 3, the main circuit further includes a power supply and a load. The first connection terminal a1 of the hybrid switching apparatus 100 is connected to a positive electrode of the power supply. The second connection terminal a2 of the hybrid switching apparatus 100 is connected to the fourth connection terminal a4 of the hybrid switching apparatus 100. The third connection terminal a3 of the hybrid switching apparatus 100 is connected to a first terminal of the load. A second terminal of the load is connected to a negative electrode of the power supply.

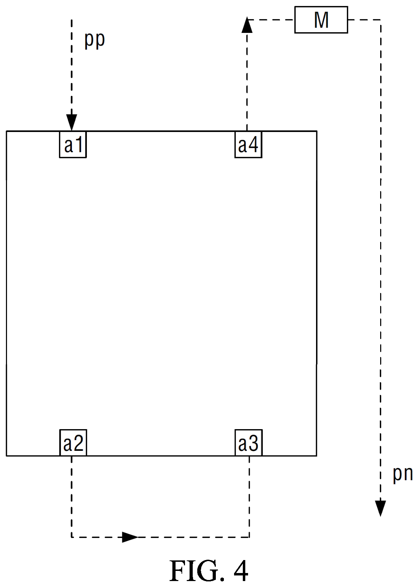

In a third possible implementation, as shown in FIG. 4, the main circuit further includes a power supply and a load. The first connection terminal a1 of the hybrid switching apparatus 100 is connected to a positive electrode of the power supply. The second connection terminal a2 of the hybrid switching apparatus 100 is connected to the third connection terminal a3 of the hybrid switching apparatus 100. The fourth connection terminal a4 of the hybrid switching apparatus 100 is connected to a first terminal of the load. A second terminal of the load is connected to a negative electrode of the power supply.

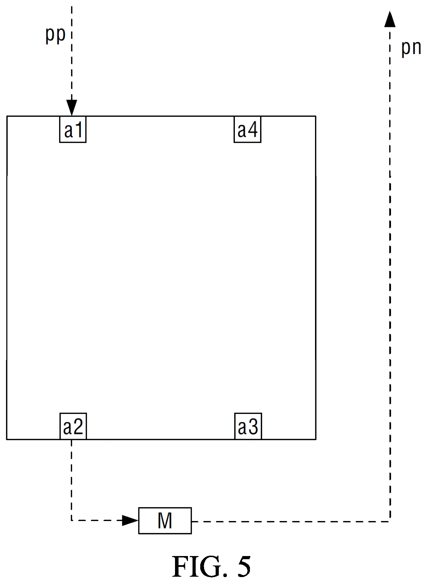

In a fourth possible implementation, as shown in FIG. 5, the main circuit further includes a power supply and a load. The first connection terminal a1 of the hybrid switching apparatus 100 is connected to a positive electrode of the power supply. The second connection terminal a2 of the hybrid switching apparatus 100 is connected to a first terminal of the load. A second terminal of the load is connected to a negative electrode of the power supply.

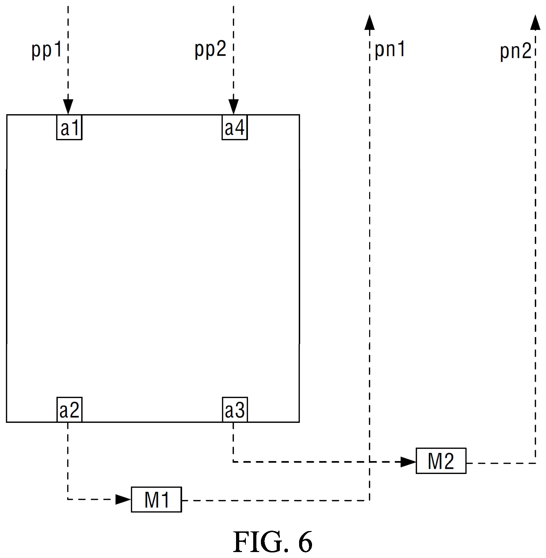

In a fifth possible implementation, as shown in FIG. 6, the main circuit further includes a first power supply, a first load, a second power supply, and a second load. The first connection terminal a1 of the hybrid switching apparatus 100 is connected to a positive electrode of the first power supply. The second connection terminal a2 of the hybrid switching apparatus 100 is connected to a first terminal of the first load. A second terminal of the first load is connected to a negative electrode of the first power supply. In addition, the fourth connection terminal a4 of the hybrid switching apparatus 100 is connected to a positive electrode of the second power supply. The third connection terminal a3 of the hybrid switching apparatus 100 is connected to a first terminal of the second load. A second terminal of the second load is connected to a negative electrode of the second power supply.

It needs to be noted that in FIG. 6, pp1 is the positive electrode of the first power supply, pn1 is the negative electrode of the first power supply, M1 is the first load, pp2 is the positive electrode of the second power supply, pn2 is the negative electrode of the second power supply, and M2 is the second load.

The load may be a power consuming device or the like. For example, the load may be a motor. If the load is a polarized load, the first terminal of the load is the positive electrode of the load, and the second terminal of the load is the negative electrode of the load. The first load and the second load are two loads of a same type or different types. The power supply may be a direct-current power supply, and the first power supply and the second power supply are two power supplies of a same type or different types. A connection between the hybrid switching apparatus 100 and the power supply may be a direct connection or an indirect connection, and a connection between the hybrid switching apparatus 100 and the load may be a direct connection or an indirect connection. This is not limited in this embodiment of this application. For example, in the foregoing first possible implementation, the first connection terminal a1 of the hybrid switching apparatus 100 may be connected to the positive electrode of the power supply by an element such as a resistor.

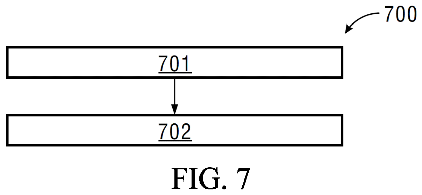

FIG. 7 is a flowchart of a turn-off control method according to an embodiment of this application. As shown in FIG. 7, the turn-off control method 700 includes the following steps.

Step 701: Send turn-off control data to a hybrid switching apparatus 100 when the hybrid switching apparatus 100 is in an on state, to turn on a first solid-state switch 103 and a second solid-state switch 105 that are included in the hybrid switching apparatus 100, and turn off a first mechanical switch 102 and a second mechanical switch 104 that are included in the hybrid switching apparatus 100. The on state is a state in which the first mechanical switch 102 and the second mechanical switch 104 that are included in the hybrid switching apparatus 100 are turned on and the first solid-state switch 103 and the second solid-state switch 105 are turned off, the first mechanical switch 102 is connected in parallel with the first solid-state switch 103, and the second mechanical switch 104 is connected in parallel with the second solid-state switch 105.

In a specific implementation, based on the foregoing hybrid switching apparatus 100, when the hybrid switching apparatus 100 is in the on state, if the hybrid switching apparatus 100 needs to be adjusted to an off state, a turn-on control signal may be sent to a driving unit 101, and a turn-off control signal may also be sent to a unit configured to control the first mechanical switch 102 and the second mechanical switch 104 to be turned off.

After the turn-on control signal is sent to the driving unit 101, the first solid-state switch 103 and the second solid-state switch 105 are turned on. After the turn-off control signal is sent to the unit configured to control the first mechanical switch 102 and the second mechanical switch 104 to be turned off, the first mechanical switch 102 and the second mechanical switch 104 are turned off. A specific structure, a connection manner, and the like of the unit configured to control the first mechanical switch 102 and the second mechanical switch 104 to be turned off are not limited in this application.

It needs to be noted that a sequence of sending the turn-on control signal and the turn-off control signal is not limited in this embodiment of this application.

Step 702: Control the first solid-state switch 103 and the second solid-state switch 105 to be turned off after current flows normally through the first solid-state switch 103 and current flows normally through the second solid-state switch 105, to switch the hybrid switching apparatus 100 to an off state.

In a specific implementation, when the first solid-state switch 103, the first mechanical switch 102, the second solid-state switch 105, and the second mechanical switch 104 are all connected in a main circuit (for example, the main circuit uses the first possible implementation, the second possible implementation, the third possible implementation, or the fifth possible implementation of the foregoing main circuit), if the hybrid switching apparatus 100 is normal, after the first solid-state switch 103 is turned on, the first mechanical switch 102 is turned off, the second solid-state switch 105 is turned on, and the second mechanical switch 104 is turned off, current in the main circuit normally flows through the first solid-state switch 103 and the second solid-state switch 105. In this case, the first solid-state switch 103 and the second solid-state switch 105 may be controlled to be turned off, so that the first solid-state switch 103, the first mechanical switch 102, the second solid-state switch 105, and the second mechanical switch 104 are all turned off. In other words, the hybrid switching apparatus 100 may be switched to the off state.

The controlling the first solid-state switch 103 and the second solid-state switch 105 to be turned off may be implemented by sending a signal having a level opposite to that of turn-on control signal to the driving unit 101. This is not limited in this embodiment of this application.

In the embodiments of this application, the turn-off control data may be sent to the hybrid switching apparatus 100 when the hybrid switching apparatus 100 is in the on state, to turn on the first solid-state switch 103 and the second solid-state switch 105 that are included in the hybrid switching apparatus 100, and turn off the first mechanical switch 102 and the second mechanical switch 104 that are included in the hybrid switching apparatus 100. Then, the first solid-state switch 103 and the second solid-state switch 105 are controlled to be turned off after current flows normally through the first solid-state switch 103 and current flows normally through the second solid-state switch 105, to switch the hybrid switching apparatus 100 to the off state. Therefore, in a process of turning off the hybrid switching apparatus 100, the first solid-state switch 103 and the second solid-state switch 105 are turned off after current flows normally through both the first solid-state switch 103 and the second solid-state switch 105, so that randomness of a turn-off sequence and a turn-off time interval of the first solid-state switch 103 and the second solid-state switch 105 is low, the coordination between the switches inside the hybrid switching apparatus 100 is improved, a possibility of generating an arc in the process of turning off the hybrid switching apparatus 100 is reduced, and the operating performance of the hybrid switching apparatus 100 is improved.

Further, considering that this application can reduce a possibility of arc generation in a process of turning off the hybrid switching apparatus 100, the hybrid switching apparatus 100 in this application may be used in direct-current circuits with higher current.

In a possible implementation, the turn-off control data includes a turn-on control signal. Based on this:
The sending turn-off control data to a hybrid switching apparatus 100 when the hybrid switching apparatus 100 is in an on state includes the following specific processing: when the hybrid switching apparatus 100 is in the on state, sending the turn-on control signal to a driving unit 101 included in the hybrid switching apparatus 100, to enable the driving unit 101 to send a first driving signal to the first solid-state switch 103, and send a second driving signal to the second solid-state switch 105, where the driving unit 101 is connected to the first solid-state switch 103, the driving unit 101 is connected to the second solid-state switch 105, the first driving signal is configured for driving the first solid-state switch 103 to be turned on, and the second driving signal is configured for driving the second solid-state switch 105 to be turned on.

In a specific implementation, based on the foregoing hybrid switching apparatus 100, when the hybrid switching apparatus 100 is in the on state and after the turn-on control signal is sent to the driving unit 101, a first amplification module D1 is configured to receive the turn-on control signal sent by a turn-off control apparatus 900, and amplify the turn-on control signal after receiving the turn-on control signal, so that a first amplified signal output by the first amplification module D1 after the turn-on control signal is received is sufficiently large. A first resistor R1 outputs the first driving signal from a first output terminal of the driving unit 101 after receiving the first amplified signal. The first driving signal can drive the first solid-state switch 103 to be turned on. A second amplification module D2 is configured to receive the turn-on control signal sent by the turn-off control apparatus 900, and amplify the turn-on control signal after receiving the turn-on control signal, so that a second amplified signal output by the second amplification module D2 after the turn-on control signal is received is sufficiently large. A second resistor R2 outputs the second driving signal from the second output terminal of the driving unit 101 after the second amplified signal is received. The second driving signal can drive the second solid-state switch 105 to be turned on.

It needs to be noted that based on the foregoing hybrid switching apparatus 100, that the first solid-state switch 103 is turned on means that a first transistor T1 and a second transistor T2 are turned on, and that the second solid-state switch 105 is turned on means that a third transistor T3 and a fourth transistor T4 are turned on.

Therefore, the first solid-state switch 103 and the second solid-state switch 105 in the hybrid switching apparatus 100 are turned on based on a received turn-on control signal, and compared with being turned on based on more signals sent by different apparatuses, costs of using hardware are reduced.

In a possible implementation, the turn-off control method 700 further includes: if it is detected that current is present on either of the first solid-state switch 103 and the second solid-state switch 105 within a first duration after the first solid-state switch 103 is turned on and the second solid-state switch 105 is turned on, determining that current flows normally through the solid-state switch; and if it is detected that current is present on the other of the first solid-state switch 103 and the second solid-state switch 105 different from the solid-state switch within a second duration after it is detected that current is present on the solid-state switch, determining that current flows normally through the other solid-state switch.

The first duration and the second duration may be set according to an actual requirement. This is not limited in this embodiment of this application. For example, the first duration may be 50 milliseconds to 100 milliseconds, and the second duration may be greater than or equal to 1 millisecond and less than 10 milliseconds.

It needs to be noted that based on the foregoing hybrid switching apparatus 100, that current is present on the first solid-state switch 103 is that current flows from a collector of the first transistor T1 to an emitter of the first transistor T1, or current flows from a collector of the second transistor T2 to an emitter of the second transistor T2, and that current is present on the second solid-state switch 105 is that current flows from a collector of the third transistor T3 to an emitter of the third transistor T3, or current flows from a collector of the fourth transistor T4 to an emitter of the fourth transistor T4.

In a specific implementation, a first current detection unit may be connected to the first solid-state switch 103. The first current detection unit is configured to detect whether current flows through the first solid-state switch 103. A second current detection unit may be connected to the second solid-state switch 105. The second current detection unit is configured to detect whether current flows through the second solid-state switch 105. Based on this:
After the turn-on control signal is sent to turn on the first solid-state switch 103 and turn on the second solid-state switch 105, the first current detection unit and the second current detection unit may further be turned on. Within the first duration after the first solid-state switch 103 is turned on and the second solid-state switch 105 is turned on, whether current is present on the first solid-state switch 103 and the second solid-state switch 105 is detected by using the first current detection unit and the second current detection unit, respectively. If it is detected by using the first current detection unit that no current is present on the first solid-state switch 103, a first current identifier corresponding to the first solid-state switch 103 is set to 0. If it is detected by using the first current detection unit that current is present on the first solid-state switch 103, the first current identifier is set to 1. If it is detected by using the second current detection unit that no current is present on the second solid-state switch 105, a second current identifier corresponding to the second solid-state switch 105 is set to 0. If it is detected by using the second current detection unit that current is present on the second solid-state switch 105, the second current identifier is set to 1.

Further, within the first duration after the first solid-state switch 103 is turned on and the second solid-state switch 105 is turned on, if it is detected first by using the first current detection unit that current is present on the first solid-state switch 103, it is determined that current flows normally through the first solid-state switch 103, and the first current identifier is set to 1, and the first current detection unit may be further turned off. If it is detected first by using the second current detection unit that current is present on the second solid-state switch 105, it is determined that current flows normally through the second solid-state switch 105, and the second current identifier is set to 1, and the second current detection unit may be further turned off. Then, an OR operation is performed on the first current identifier and the second current identifier, to obtain that a result of the OR operation is 1. The second duration starts to be timed, and an AND operation is performed on the first current identifier and the second current identifier periodically within the second duration until a result of the AND operation is 1. In this case, it may be determined that it is detected that current is present on the other solid-state switch (if it is first detected by using the first current detection unit that current is present on the first solid-state switch 103 within the first duration after the first solid-state switch 103 is turned on and the second solid-state switch 105 is turned on, the other solid-state switch is the second solid-state switch 105; if it is first detected by using the second current detection unit that current is present on the second solid-state switch 105 within the first duration after the first solid-state switch 103 is turned on and the second solid-state switch 105 is turned on, the other solid-state switch is the first solid-state switch 103), and it is determined that current flows normally through the other solid-state switch. Then, result data of the OR operation may be deleted, and the current detection unit corresponding to the other solid-state switch (if the other solid-state switch is the first solid-state switch 103, the current detection unit corresponding to the other solid-state switch is the first current detection unit; and if the other solid-state switch is the second solid-state switch 105, the current detection unit corresponding to the other solid-state switch is the second current detection unit) is turned off.

The first current detection unit and the second current detection unit may both be units including elements such as an ammeter. This is not limited in this embodiment of this application.

Therefore, that current flows normally through either of the solid-state switches may be determined by setting the first duration, and that current flows normally through the other solid-state switch may be determined by setting the second duration, thereby facilitating detection of an abnormality in the hybrid switching apparatus 100.

In a possible implementation, the turn-off control method 700 further includes: if it is detected that no current is present on the first solid-state switch 103 and it is detected that no current is present on the second solid-state switch 105 within the first duration after the first solid-state switch 103 is turned on and the second solid-state switch 105 is turned on, performing a first abnormality handling.

The first abnormality handling includes: controlling the first solid-state switch 103 and the second solid-state switch 105 to be turned off after the first duration has elapsed after the first solid-state switch 103 is turned on and the second solid-state switch 105 is turned on.

In a specific implementation, if it is detected by using the first current detection unit that no current is present on the first solid-state switch 103 and it is detected by using the second current detection unit that no current is present on the second solid-state switch 105 within the first duration after the first solid-state switch 103 is turned on and the second solid-state switch 105 is turned on, the first solid-state switch 103 and the second solid-state switch 105 are controlled to be turned off after the first duration has elapsed after the first solid-state switch 103 is turned on and the second solid-state switch 105 is turned on. Therefore, if it is still detected that no current is present on the first solid-state switch 103 and the second solid-state switch 105 within the first duration after the first solid-state switch 103 and the second solid-state switch 105 are turned on, it indicates that the hybrid switching apparatus 100 operates abnormally or is incorrectly wired. In this case, the first solid-state switch 103 and the second solid-state switch 105 may still be turned off, thereby reducing a leakage risk after the hybrid switching apparatus 100 is abnormal.

In a possible implementation, the turn-off control method 700 further includes: controlling the first solid-state switch 103 and the second solid-state switch 105 to be turned on for a fourth duration and then turned off after a third duration has elapsed after the first abnormality handling is performed.

The third duration and the fourth duration may be set according to an actual requirement. This is not limited in this embodiment of this application. For example, the third duration and the fourth duration may both be close to or equal to the second duration.

In this embodiment of this application, after the first abnormality handling is performed, the first solid-state switch 103 and the second solid-state switch 105 may be controlled to be turned on again and then be turned off, and a part of residual current in the main circuit and the hybrid switching apparatus 100 may be released, thereby improving safety.

In a possible implementation, the turn-off control method 700 further includes: if it is detected that no current is present on the other solid-state switch within the second duration after it is detected that current is present on the solid-state switch, performing a second abnormality handling.

The second abnormality handling includes: controlling the first solid-state switch 103 and the second solid-state switch 105 to be turned off after the second duration has elapsed after it is detected that current is present on the solid-state switch.

In this embodiment of this application, if it is detected that no current is present on the other solid-state switch within the second duration after it is detected that current is present on the solid-state switch, it indicates that the hybrid switching apparatus 100 operates abnormally, or the other solid-state switch and a corresponding mechanical switch are not connected in the main circuit (for example, the main circuit uses the fourth possible implementation of the foregoing main circuit). In this case, the first solid-state switch 103 and the second solid-state switch 105 can still be turned off, so that the hybrid switching apparatus 100 can be turned off, thereby further reducing a leakage risk after the hybrid switching apparatus 100 is abnormal.

In a possible implementation, the controlling the first solid-state switch 103 and the second solid-state switch 105 to be turned off after current flows normally through the first solid-state switch 103 and current flows normally through the second solid-state switch 105 in the foregoing step 702 includes: controlling the first solid-state switch 103 and the second solid-state switch 105 to be turned off after a fifth duration has elapsed after current flows normally through the first solid-state switch 103 and current flows normally through the second solid-state switch 105.

The fifth duration may be set according to an actual requirement. This is not limited in this embodiment of this application. For example, the fifth duration may be equal to or close to half of the second duration.

Therefore, before the hybrid switching apparatus 100 is completely turned off, current may sufficiently flow through the first solid-state switch 103 and the second solid-state switch 105 within the fifth duration, so that the first solid-state switch 103 and the second solid-state switch 105 reach a relatively stable state, thereby reducing a possibility of arc generation.

Alternatively, in this application, when the first solid-state switch 103 and the second solid-state switch 105 are controlled to be turned off, the first solid-state switch 103 and the second solid-state switch 105 may be controlled to be turned off at the same time, thereby further reducing the possibility of arc generation. In a possible implementation, the turn-off control method 700 further includes: after a sixth duration has elapsed after the first solid-state switch 103 and the second solid-state switch 105 are controlled to be turned off, controlling a first disconnector 106 and a second disconnector 107 that are included in the hybrid switching apparatus 100 to be turned off, where the first disconnector 106 is connected in series with the first mechanical switch 102, and the second disconnector 107 is connected in series with the second mechanical switch 104. The sixth duration may be set according to an actual requirement. This is not limited in this embodiment of this application. For example, the fifth duration may be equal to or close to half of the second duration.

Therefore, after the hybrid switching apparatus 100 is turned off, the first disconnector 106 and the second disconnector 107 may be turned off, thereby reducing a possibility of accidental conduction of the main circuit after interruption and improving safety.
Further, the turn-off control method 700 in this application can normally run when the first mechanical switch 102, the first solid-state switch 103, the second mechanical switch 104, and the second solid-state switch 105 are all connected in the main circuit, and can also run normally when the first mechanical switch 102 and the first solid-state switch 103 are connected in the main circuit while the second mechanical switch 104 and the second solid-state switch 105 are not connected in the main circuit, so that application scenarios are wide.

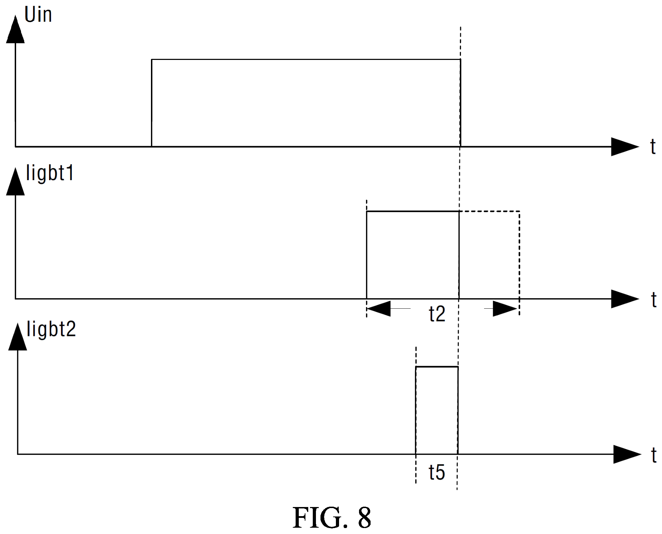

Based on the foregoing turn-off control method 700 and the hybrid switching apparatus 100, when the main circuit uses the first possible implementation, the second possible implementation, or the third possible implementation of the foregoing main circuit, a timing relationship among power supply output voltage, the current that flows through the first solid-state switch 103, and the current that flows through the second solid-state switch 105 may be shown in FIG. 8. Uin is the power supply output voltage, Iigbt1 is the current that flows through the first solid-state switch 103, Iigbt2 is the current that flows through the second solid-state switch 105, t is time, t2 is the second duration, and t5 is the fifth duration.

### Turn-off control apparatus

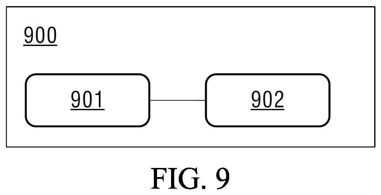

Corresponding to the foregoing method embodiment, FIG. 9 is a schematic diagram of a turn-off control apparatus according to an embodiment of this application. As shown in FIG. 9, the turn-off control apparatus 900 includes:
a sending unit 901, configured to send turn-off control data to a hybrid switching apparatus 100 when the hybrid switching apparatus 100 is in an on state, to turn on a first solid-state switch 103 and a second solid-state switch 105 that are included in the hybrid switching apparatus 100, and turn off a first mechanical switch 102 and a second mechanical switch 104 that are included in the hybrid switching apparatus 100, where the on state is a state in which the first mechanical switch 102 and the second mechanical switch 104 that are included in the hybrid switching apparatus 100 are turned on and the first solid-state switch 103 and the second solid-state switch 105 are turned off, the first mechanical switch 102 is connected in parallel with the first solid-state switch 103, and the second mechanical switch 104 is connected in parallel with the second solid-state switch 105; and
a turn-off unit 902, configured to control the first solid-state switch 103 and the second solid-state switch 105 to be turned off after current flows normally through the first solid-state switch 103 and current flows normally through the second solid-state switch 105, to switch the hybrid switching apparatus 100 to an off state.

In this embodiment of this application, the sending unit 901 may be configured to perform step 701 in the foregoing method embodiments, and the turn-off unit 902 may be configured to perform step 702 in the foregoing method embodiments.

It needs to be noted that since the content such as the information exchange between and the execution processes of the units in the turn-off control apparatus 900 described above are based on the same concept as the foregoing embodiment of the turn-off control method 700, for details, reference may be made to the description in the foregoing embodiment of the turn-off control method 700. Details are not described herein again.

### Electronic device

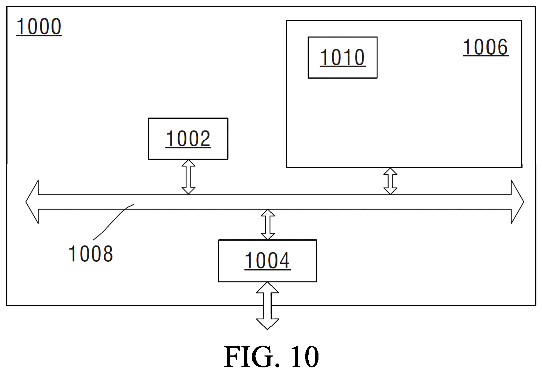

FIG. 10 is a schematic diagram of an electronic device according to an embodiment of this application. Specific embodiments of this application do not limit specific implementations of the electronic device. Referring to FIG. 10, the electronic device 1000 provided in this embodiment of this application includes a processor 1002, a communication interface 1004, a memory 1006, and a bus 1008. The processor 1002, the communication interface 1004, and the memory 1006 implement communication with each other through the bus 1008.

The communication interface 1004 is configured to communicate with another electronic device or server.

The processor 1002 is configured to execute a program 1010, and specifically, may perform related steps in the foregoing embodiment of the turn-off control method. Specifically, the program 1010 may include program code, and the program code includes computer operation instructions.

The processor 1002 may be a central processing unit (CPU), an application specific integrated circuit (ASIC), or one or more integrated circuits configured to implement the embodiments of this application. One or more processors included in a smart device may be one type of processor, for example, one or more CPUs; or may be different types of processors, for example, one or more CPUs and one or more ASICs.

The memory 1006 is configured to store a program 1010. The memory 1006 may include a high-speed RAM, and may further include a non-volatile memory (non-volatile memory), for example, at least one magnetic disk memory.

The program 1010 may be specifically configured to cause the processor 1002 to perform the turn-off control method according to any one of the foregoing embodiments.

For the specific implementation of each step in the program 1010, reference may be made to corresponding descriptions in corresponding steps and units in the foregoing embodiment of the turn-off control method. Details are not described herein. It may be clearly understood by persons skilled in the art that, for the purpose of convenient and brief description, for a detailed working process of the foregoing devices and modules, reference may be made to the description of a corresponding process in the foregoing method embodiments, and details are not described herein again.

In the electronic device in this embodiment, the turn-off control data may be sent to the hybrid switching apparatus when the hybrid switching apparatus is in the on state, to turn on the first solid-state switch and the second solid-state switch that are included in the hybrid switching apparatus, and turn off the first mechanical switch and the second mechanical switch that are included in the hybrid switching apparatus. Then, the first solid-state switch and the second solid-state switch are controlled to be turned off after current flows normally through the first solid-state switch and current flows normally through the second solid-state switch, to switch the hybrid switching apparatus to the off state. Therefore, in a process of turning off the hybrid switching apparatus, the first solid-state switch and the second solid-state switch are turned off after current flows normally through both the first solid-state switch and the second solid-state switch, so that randomness of a turn-off sequence and a turn-off time interval of the first solid-state switch and the second solid-state switch is low, the coordination between the switches inside the hybrid switching apparatus is improved, a possibility of generating an arc in the process of turning off the hybrid switching apparatus is reduced, and the operating performance of the hybrid switching apparatus is improved.

### Computer-readable storage medium

This application further provides a computer-readable storage medium, storing instructions for causing a machine to perform the turn-off control method as described herein. Particularly, a system or an apparatus configured with a storage medium may be provided. The storage medium stores software program code for implementing functions in any one of the foregoing embodiments, and a computer (or a CPU or an MPU) of the system or the apparatus is enabled to read and execute the program code stored in the storage medium.

In this case, the program code read from the storage medium can implement the functions in any one of the foregoing embodiments. Therefore, the program code and the storage medium for storing the program code constitute a part of this application.

Embodiments of the storage medium for providing the program code include a floppy disk, a hard disk, a magneto-optical disk, an optical disk (for example, a CD-ROM, a CD-R, a CD-RW, a DVD-ROM, a DVD-RAM, a DVD-RW, or a DVD-RW), a magnetic tape, a non-volatile storage card, and a ROM. Optionally, the program code may be downloaded from a server computer through a communications network.

In addition, it should be clear that not only the program code read by the computer may be executed, but also an operating system and the like operated on the computer may be enabled to complete some or all actual operations by using an instruction based on the program code, so as to implement the functions of any one of the foregoing embodiments.

In addition, it may be understood that the program code read from the storage medium is written into a memory disposed in an expansion board inserted into the computer or is written into a memory disposed in an expansion module connected to the computer, and subsequently, a CPU or the like installed on the expansion board or the expansion module is enabled to perform some or all actual operations based on the instructions of the program code, so as to implement the functions of any one of the foregoing embodiments.

### Computer program product

The embodiments of this application further provide a computer program product, tangibly stored in a computer-readable medium and including computer-executable instructions, where the computer-executable instructions, when executed, cause at least one processor to perform the turn-off control method provided in the embodiments. It should be understood that the solutions in this embodiment have corresponding technical effects in the foregoing method embodiments. Details are not described herein again.

It should be noted that not all steps and modules in the flowcharts and structural diagrams of the apparatuses are necessary, and some steps or modules may be omitted according to an actual requirement. An execution sequence of the steps is not fixed and may be adjusted as required. The system structure described in the foregoing embodiments may be a physical structure or a logical structure. To be specific, some modules may be implemented by a same physical entity, or some units may be implemented by a plurality of physical entities, or may be implemented by some components in a plurality of independent devices together. The nouns and pronouns related to persons in this application are not limited to a specific gender.

In the foregoing embodiments, the hardware modules may be implemented mechanically or electrically. For example, a hardware module may include a permanent dedicated circuit or logic (for example, a dedicated processor, an FPGA, or an ASIC) to complete a corresponding operation. The hardware module may further include a programmable logic or circuit (for example, a general-purpose processor or another programmable processor), which may be temporarily set by software to complete a corresponding operation. A specific implementation (a mechanical manner, a dedicated permanent circuit, or a temporarily set circuit) may be determined based on costs and time considerations.

This application has been described above in detail through the accompanying drawings and preferred embodiments. However, this application is not limited to these disclosed embodiments. Based on the foregoing various embodiments, those skilled in the art can understand that the code review methods in the above different embodiments may be combined to obtain more embodiments of this application, which, however, also fall within the scope of protection of this application.

### Hybrid switching apparatus

The embodiments of this application further provide a hybrid switching apparatus 100. As shown in FIG. 1, the hybrid switching apparatus 100 includes a first mechanical switch 102, a first solid-state switch 103, a second mechanical switch 104, and a second solid-state switch 105. The first mechanical switch 102 is connected in parallel with the first solid-state switch 103. The second mechanical switch 104 is connected in parallel with the second solid-state switch 105.

The first mechanical switch 102 and the second mechanical switch 104 are both configured to be turned off after a turn-off control apparatus 900 connected to the hybrid switching apparatus 100 sends at least some turn-off control data to the hybrid switching apparatus 100 when the hybrid switching apparatus 100 is in an on state. The on state is a state in which the first mechanical switch 102 and the second mechanical switch 104 that are included in the hybrid switching apparatus 100 are turned on and the first solid-state switch 103 and the second solid-state switch 105 are turned off.

The first solid-state switch 103 and the second solid-state switch 105 are both configured to be turn on after the turn-off control apparatus 900 sends at least some turn-off control data to the hybrid switching apparatus 100 and turned off after current flows normally through the first solid-state switch 103 and current flows normally through the second solid-state switch 105 when the hybrid switching apparatus 100 is in the on state, to switch the hybrid switching apparatus 100 to an off state.

In a possible implementation, the hybrid switching apparatus 100 further includes a driving unit 101. The driving unit 101 is connected to the first solid-state switch 103 and connected to the second solid-state switch 105, and is configured to send a first driving signal to the first solid-state switch 103 and send a second driving signal to the second solid-state switch 105 after the turn-off control apparatus 900 sends a turn-on control signal included in the turn-off control data to the hybrid switching apparatus 100 when the hybrid switching apparatus 100 is in the on state. The first solid-state switch 103 is configured to be turned on after the first driving signal is received. The second solid-state switch 105 is configured to be turned on after the second driving signal is received.

In a possible implementation, the first solid-state switch 103 includes a first transistor T1, a second transistor T2, a first diode L1, and a second diode L2. The second solid-state switch 105 includes a third transistor T3, a fourth transistor T4, a third diode L3, and a fourth diode L4. The first transistor T1, the second transistor T2, the third transistor T3, and the fourth transistor T4 are all N-channel insulated gate bipolar transistors. A first connection terminal a1 of the hybrid switching apparatus 100 is connected to a first terminal of the first mechanical switch 102. A second connection terminal a2 of the hybrid switching apparatus 100 is connected to a second terminal of the first mechanical switch 102. A third connection terminal a3 of the hybrid switching apparatus 100 is connected to a first terminal of the second mechanical switch 104. A fourth connection terminal a4 of the hybrid switching apparatus 100 is connected to a second terminal of the second mechanical switch 104.

A gate of the first transistor T1 is connected to a first output terminal that is of the driving unit 101 and that is configured to output the first driving signal. A collector of the first transistor T1 is connected to the first terminal of the first mechanical switch 102. An emitter of the first transistor T1 is connected to an emitter of the second transistor T2. A gate of the second transistor T2 is connected to the first output terminal of the driving unit 101. A collector of the second transistor T2 is connected to the second terminal of the first mechanical switch 102. The emitter of the first transistor T1 and the emitter of the second transistor T2 are connected to ground. An anode of the first diode L1 is connected to the emitter of the first transistor T1. A cathode of the first diode L1 is connected to the collector of the first transistor T1. An anode of the second diode L2 is connected to the emitter of the second transistor T2. A cathode of the second diode L2 is connected to the collector of the second transistor T2.

A gate of the third transistor T3 is connected to a second output terminal that is of the driving unit 101 and that is configured to output the second driving signal. A collector of the third transistor T3 is connected to the first terminal of the second mechanical switch 104. An emitter of the third transistor T3 is connected to an emitter of the fourth transistor T4. A gate of the fourth transistor T4 is connected to the second output terminal of the driving unit 101. A collector of the fourth transistor T4 is connected to the second terminal of the second mechanical switch 104. The emitter of the third transistor T3 and the emitter of the fourth transistor T4 are connected to ground. An anode of the third diode L3 is connected to the emitter of the third transistor T3. A cathode of the third diode L3 is connected to the collector of the third transistor T3. An anode of the fourth diode L4 is connected to the emitter of the fourth transistor T4. A cathode of the fourth diode L4 is connected to the collector of the fourth transistor T4.

In a possible implementation, the driving unit 101 includes a first amplification module D1, a first resistor R1, a first capacitor C1, a second amplification module D2, a second resistor R2, and a second capacitor C2. An input terminal of the first amplification module D1 is connected to the turn-off control apparatus 900. An output terminal of the first amplification module D1 is connected to a first terminal of the first resistor R1. The first amplification module D1 is configured to receive the turn-on control signal, and amplify the turn-on control signal after receiving the turn-on control signal. A second terminal of the first resistor R1 is the first output terminal. A first terminal of the first capacitor C1 is connected to the second terminal of the first resistor R1. A second terminal of the first capacitor C1 is connected to ground. An input terminal of the second amplification module D2 is connected to the turn-off control apparatus 900. An output terminal of the second amplification module D2 is connected to a first terminal of the second resistor R2. The second amplification module D2 is configured to receive the turn-on control signal, and amplify the turn-on control signal after receiving the turn-on control signal. A second terminal of the second resistor R2 is the second output terminal. A first terminal of the second capacitor C2 is connected to the second terminal of the second resistor R2. A second terminal of the second capacitor C2 is connected to ground.

In a possible implementation, the hybrid switching apparatus 100 further includes a first disconnector 106 and a second disconnector 107. A first terminal of the first disconnector 106 is connected to the first terminal of the first mechanical switch 102, and a second terminal of the first disconnector 106 is connected to the first connection terminal a1 of the hybrid switching apparatus 100. A first terminal of the second disconnector 107 is connected to the first terminal of the second mechanical switch 104, and a second terminal of the second disconnector 107 is connected to the third connection terminal a3 of the hybrid switching apparatus 100.

It needs to be noted that since the content such as the information exchange between and the execution processes of the units in the hybrid switching apparatus 100, and the like is described in the foregoing embodiment of the turn-off control method 700. For specific content, reference may be made to the description in the foregoing embodiment of the turn-off control method 700, and details are not described herein again.

It should be noted that the relational terms herein such as "first" and "second" are used only to differentiate an entity or operation from another entity or operation, and do not require or imply any actual relationship or sequence between these entities or operations. Moreover, the terms "include," "comprise," and any variation thereof are intended to cover a non-exclusive inclusion. Therefore, in the context of a process, a method, an object, or a device that includes a series of elements, the process, method, object, or device not only includes such elements, but also includes other elements not specified expressly, or may include inherent elements of the process, method, object, or device. If no more limitations are made, an element limited by "include a/an..." does not exclude other same elements existing in the process, the method, the object or the device which includes the element.

All steps and modules in the flowcharts and structural diagrams of the systems are necessary, and some steps or modules may be omitted according to an actual requirement. An execution sequence of the steps is not fixed and may be adjusted as required. The system structure described in the foregoing embodiments may be a physical structure or a logical structure. To be specific, some modules may be implemented by a same physical entity, or some units may be implemented by a plurality of physical entities, or may be implemented by some components in a plurality of independent devices together.

In the foregoing embodiments, the hardware modules may be implemented mechanically or electrically. For example, a hardware module may include a permanent dedicated circuit or logic (for example, a dedicated processor, an FPGA, or an ASIC) to complete a corresponding operation. The hardware module may further include a programmable logic or circuit (for example, a general-purpose processor or another programmable processor), which may be temporarily set by software to complete a corresponding operation. A specific implementation (a mechanical manner, a dedicated permanent circuit, or a temporarily set circuit) may be determined based on costs and time considerations.

This application has been described above in detail through the accompanying drawings and preferred embodiments. However, this application is not limited to these disclosed embodiments. Based on the foregoing various embodiments, those skilled in the art can understand that the code review methods in the above different embodiments may be combined to obtain more embodiments of this application, which, however, also fall within the scope of protection of this application.

## Claims

1. A turn-off control method (700), comprising:
sending turn-off control data to a hybrid switching apparatus (100) when the hybrid switching apparatus (100) is in an on state, to turn on a first solid-state switch (103) and a second solid-state switch (105) that are comprised in the hybrid switching apparatus (100), and turn off a first mechanical switch (102) and a second mechanical switch (104) that are comprised in the hybrid switching apparatus (100), wherein the on state is a state in which the first mechanical switch (102) and the second mechanical switch (104) that are comprised in the hybrid switching apparatus (100) are turned on and the first solid-state switch (103) and the second solid-state switch (105) are turned off, the first mechanical switch (102) is connected in parallel with the first solid-state switch (103), and the second mechanical switch (104) is connected in parallel with the second solid-state switch (105); and
controlling the first solid-state switch (103) and the second solid-state switch (105) to be turned off after current flows normally through the first solid-state switch (103) and current flows normally through the second solid-state switch (105), to switch the hybrid switching apparatus (100) to an off state.

2. The method according to claim 1, wherein the method further comprises:
if it is detected that current is present on either of the first solid-state switch (103) and the second solid-state switch (105) within a first duration after the first solid-state switch (103) is turned on and the second solid-state switch (105) is turned on, determining that current flows normally through the solid-state switch; and
if it is detected that current is present on the other of the first solid-state switch (103) and the second solid-state switch (105) different from the solid-state switch within a second duration after it is detected that current is present on the solid-state switch, determining that current flows normally through the other solid-state switch.

3. The method according to claim 2, wherein the method further comprises:
if it is detected that no current is present on the first solid-state switch (103) and it is detected that no current is present on the second solid-state switch (105) within the first duration after the first solid-state switch (103) is turned on and the second solid-state switch (105) is turned on, performing a first abnormality handling, wherein the first abnormality handling comprises: controlling the first solid-state switch (103) and the second solid-state switch (105) to be turned off after the first duration has elapsed after the first solid-state switch (103) is turned on and the second solid-state switch (105) is turned on.

4. The method according to claim 3, wherein the method further comprises:
controlling the first solid-state switch (103) and the second solid-state switch (105) to be turned on for a fourth duration and then turned off after a third duration has elapsed after the first abnormality handling is performed.

5. The method according to claim 2, wherein the method further comprises:
if it is detected that no current is present on the other solid-state switch within the second duration after it is detected that current is present on the solid-state switch, performing a second abnormality handling, wherein the second abnormality handling comprises: controlling the first solid-state switch (103) and the second solid-state switch (105) to be turned off after the second duration has elapsed after it is detected that current is present on the solid-state switch.

6. The method according to claim 1, wherein the controlling the first solid-state switch (103) and the second solid-state switch (105) to be turned off after current flows normally through the first solid-state switch (103) and current flows normally through the second solid-state switch (105) comprises:
controlling the first solid-state switch (103) and the second solid-state switch (105) to be turned off after a fifth duration has elapsed after current flows normally through the first solid-state switch (103) and current flows normally through the second solid-state switch (105).

7. The method according to claim 1, wherein the method further comprises:
after a sixth duration has elapsed after the first solid-state switch (103) and the second solid-state switch (105) are controlled to be turned off, controlling a first disconnector (106) and a second disconnector (107) that are comprised in the hybrid switching apparatus (100) to be turned off, wherein the first disconnector (106) is connected in series with the first mechanical switch (102), and the second disconnector (107) is connected in series with the second mechanical switch (104).

8. The method according to claim 1, wherein the turn-off control data comprises a turn-on control signal; and
the sending turn-off control data to a hybrid switching apparatus (100) when the hybrid switching apparatus (100) is in an on state comprises:
when the hybrid switching apparatus (100) is in the on state, sending the turn-on control signal to a driving unit (101) comprised in the hybrid switching apparatus (100), to enable the driving unit (101) to send a first driving signal to the first solid-state switch (103), and send a second driving signal to the second solid-state switch (105), wherein the driving unit (101) is connected to the first solid-state switch (103), the driving unit (101) is connected to the second solid-state switch (105), the first driving signal is configured for driving the first solid-state switch (103) to be turned on, and the second driving signal is configured for driving the second solid-state switch (105) to be turned on.

9. A turn-off control apparatus (900), comprising:
a sending unit (901), configured to send turn-off control data to a hybrid switching apparatus (100) when the hybrid switching apparatus (100) is in an on state, to turn on a first solid-state switch (103) and a second solid-state switch (105) that are comprised in the hybrid switching apparatus (100), and turn off a first mechanical switch (102) and a second mechanical switch (104) that are comprised in the hybrid switching apparatus (100), wherein the on state is a state in which the first mechanical switch (102) and the second mechanical switch (104) that are comprised in the hybrid switching apparatus (100) are turned on and the first solid-state switch (103) and the second solid-state switch (105) are turned off, the first mechanical switch (102) is connected in parallel with the first solid-state switch (103), and the second mechanical switch (104) is connected in parallel with the second solid-state switch (105); and
a turn-off unit (902), configured to control the first solid-state switch (103) and the second solid-state switch (105) to be turned off after current flows normally through the first solid-state switch (103) and current flows normally through the second solid-state switch (105), to switch the hybrid switching apparatus (100) to an off state.

10. An electronic device (1000), comprising: a processor (1002), a communication interface (1004), a memory (1006), and a bus (1008), wherein the processor (1002), the communication interface (1004), and the memory (1006) communicate with each other through the bus (1008); and
the memory (1006) is configured to store at least one executable instruction, and the executable instruction causes the processor (1002) to perform operations corresponding to the method according to any one of claims 1 to 8.

11. A computer-readable storage medium, having computer instructions stored therein, wherein the computer instructions, when executed by a processor, cause the processor to perform the method according to any one of claims 1 to 8.

12. A computer program product, tangibly stored in a computer-readable medium and comprising computer-executable instructions, wherein the computer-executable instructions, when executed, cause at least one processor to perform the method according to any one of claims 1 to 8.

13. A hybrid switching apparatus (100), comprising a first mechanical switch (102), a first solid-state switch (103), a second mechanical switch (104), and a second solid-state switch (105), wherein
the first mechanical switch (102) is connected in parallel with the first solid-state switch (103), and the second mechanical switch (104) is connected in parallel with the second solid-state switch (105);
the first mechanical switch (102) and the second mechanical switch (104) are both configured to be turned off after a turn-off control apparatus (900) connected to the hybrid switching apparatus (100) sends at least some turn-off control data to the hybrid switching apparatus (100) when the hybrid switching apparatus (100) is in an on state, wherein the on state is a state in which the first mechanical switch (102) and the second mechanical switch (104) that are comprised in the hybrid switching apparatus (100) are turned on and the first solid-state switch (103) and the second solid-state switch (105) are turned off; and
the first solid-state switch (103) and the second solid-state switch (105) are both configured to be turn on after the turn-off control apparatus (900) sends at least some turn-off control data to the hybrid switching apparatus (100) and turned off after current flows normally through the first solid-state switch (103) and current flows normally through the second solid-state switch (105) when the hybrid switching apparatus (100) is in the on state, to switch the hybrid switching apparatus (100) to an off state.

14. The apparatus according to claim 13, wherein the hybrid switching apparatus (100) further comprises a driving unit (101);
the driving unit (101) is connected to the first solid-state switch (103) and connected to the second solid-state switch (105), and is configured to send a first driving signal to the first solid-state switch (103) and send a second driving signal to the second solid-state switch (105) after the turn-off control apparatus (900) sends a turn-on control signal comprised in the turn-off control data to the hybrid switching apparatus (100) when the hybrid switching apparatus (100) is in the on state;
the first solid-state switch (103) is configured to be turned on after the first driving signal is received; and
the second solid-state switch (105) is configured to be turned on after the second driving signal is received.

15. The apparatus according to claim 14, wherein the first solid-state switch (103) comprises a first transistor (T1), a second transistor (T2), a first diode (L1), and a second diode (L2), the second solid-state switch (105) comprises a third transistor (T3), a fourth transistor (T4), a third diode (L3), and a fourth diode (L4), and the first transistor (T1), the second transistor (T2), the third transistor (T3), and the fourth transistor (T4) are all N-channel insulated gate bipolar transistors; a first connection terminal (a1) of the hybrid switching apparatus (100) is connected to a first terminal of the first mechanical switch (102), a second connection terminal (a2) of the hybrid switching apparatus (100) is connected to a second terminal of the first mechanical switch (102), a third connection terminal (a3) of the hybrid switching apparatus (100) is connected to a first terminal of the second mechanical switch (104), and a fourth connection terminal (a4) of the hybrid switching apparatus (100) is connected to a second terminal of the second mechanical switch (104);
a gate of the first transistor (T1) is connected to a first output terminal that is of the driving unit (101) and that is configured to output the first driving signal, a collector of the first transistor (T1) is connected to the first terminal of the first mechanical switch (102), an emitter of the first transistor (T1) is connected to an emitter of the second transistor (T2), a gate of the second transistor (T2) is connected to the first output terminal of the driving unit (101), a collector of the second transistor (T2) is connected to the second terminal of the first mechanical switch (102), and the emitter of the first transistor (T1) and the emitter of the second transistor (T2) are connected to ground; an anode of the first diode (L1) is connected to the emitter of the first transistor (T1), a cathode of the first diode (L1) is connected to the collector of the first transistor (T1), an anode of the second diode (L2) is connected to the emitter of the second transistor (T2), and a cathode of the second diode (L2) is connected to the collector of the second transistor (T2); and
a gate of the third transistor (T3) is connected to a second output terminal that is of the driving unit (101) and that is configured to output the second driving signal, a collector of the third transistor (T3) is connected to the first terminal of the second mechanical switch (104), an emitter of the third transistor (T3) is connected to an emitter of the fourth transistor (T4), a gate of the fourth transistor (T4) is connected to the second output terminal of the driving unit (101), a collector of the fourth transistor (T4) is connected to the second terminal of the second mechanical switch (104), and the emitter of the third transistor (T3) and the emitter of the fourth transistor (T4) are connected to ground; and an anode of the third diode (L3) is connected to the emitter of the third transistor (T3), a cathode of the third diode (L3) is connected to the collector of the third transistor (T3), an anode of the fourth diode (L4) is connected to the emitter of the fourth transistor (T4), and a cathode of the fourth diode (L4) is connected to the collector of the fourth transistor (T4).

16. The apparatus according to claim 15, wherein the driving unit (101) comprises a first amplification module (D1), a first resistor (R1), a first capacitor (C1), a second amplification module (D2), a second resistor (R2), and a second capacitor (C2);
an input terminal of the first amplification module (D1) is connected to the turn-off control apparatus (900), an output terminal of the first amplification module (D1) is connected to a first terminal of the first resistor (R1), the first amplification module (D1) is configured to receive the turn-on control signal, and amplify the turn-on control signal after receiving the turn-on control signal, a second terminal of the first resistor (R1) is the first output terminal, a first terminal of the first capacitor (C1) is connected to the second terminal of the first resistor (R1), and a second terminal of the first capacitor (C1) is connected to ground; and
an input terminal of the second amplification module (D2) is connected to the turn-off control apparatus (900), an output terminal of the second amplification module (D2) is connected to a first terminal of the second resistor (R2), the second amplification module (D2) is configured to receive the turn-on control signal, and amplify the turn-on control signal after receiving the turn-on control signal, a second terminal of the second resistor (R2) is the second output terminal, a first terminal of the second capacitor (C2) is connected to the second terminal of the second resistor (R2), and a second terminal of the second capacitor (C2) is connected to ground.

17. The apparatus according to claim 15 or 16, wherein the hybrid switching apparatus (100) further comprises a first disconnector (106) and a second disconnector (107);
a first terminal of the first disconnector (106) is connected to the first terminal of the first mechanical switch (102), and a second terminal of the first disconnector (106) is connected to the first connection terminal (a1) of the hybrid switching apparatus (100); and
a first terminal of the second disconnector (107) is connected to the first terminal of the second mechanical switch (104), and a second terminal of the second disconnector (107) is connected to the third connection terminal (a3) of the hybrid switching apparatus (100).
